# EUROPÄISCHE PATENTSCHRIFT

(11) **EP 0 924 148 B1**
(45) Veröffentlichungstag und Bekanntmachung des Hinweises auf die Patenterteilung: **10.01.2001**
(21) Anmeldenummer: 98122050.2
(22) Anmeldetag: 20.11.1998
(51) Int. Cl.: B65G 47/91

(54) **Vorrichtung zum Transport dünner, scheibenförmiger Gegenstände**
Device for transferring small circular articles
Dispositif pour transporter des articles circulaires minces

(30) Priorität: 16.12.1997 DE 19755694
(43) Veröffentlichungstag der Anmeldung: 23.06.1999
(73) Patentinhaber: SEZ Semiconductor-Equipment Zubehör für die Halbleiterfertigung AG, 9500 Villach (AT)
(72) Erfinder: Pirker, Willibald, 9530 Bad Bleiberg (Kärnten) (AT)

(56) Entgegenhaltungen:
- EP-A- 0 277 683
- AT-U- 640
- GB-A- 748 138
- US-A- 3 523 706
- US-A- 4 118 058
- US-A- 4 969 676

## Beschreibung

Die Erfindung betrifft eine Vorrichtung zum Transport dünner, scheibenförmiger Gegenstände.

Bei der Herstellung von Halbleitern werden sogenannte Wafer (Siliciumscheiben) verwendet, auf die zunächst in wechselnder Reihenfolge und mehrfach hintereinander vor allem Oxid-, Nitrid-, Polysilicium- und Metallschichten aufgebracht werden. Im Laufe des weiteren Herstellungsprozesses werden diese, oft nur wenige Nanometer dicken Schichten von der Vorderseite meist bereichsweise und von der Rückseite meist vollständig weggeätzt. Die Ätzung kann trocken oder flüssig erfolgen. Bekannt ist in diesem Zusammenhang die sogenannte Spin-Etch-Technologie (ein Rotationsätzverfahren).

Der zu bearbeitende scheibenförmige Wafer wird dazu aus einer sogenannten Waferkassette entnommen und mit der zu schützenden Seite nach unten auf einen sogenannten Chuck (eine Wafer-Haltevorrichtung) gesetzt.

Im Chuck findet der Ätzvorgang statt, wobei in modernen Anlagen in ein und demselben Chuck mehrere Ätzvorgänge mit unterschiedlichen Säuremischungen sequentiell ausgeführt werden.

Nach Beendigung des Ätzprozesses wird der Wafer vom Chuck entnommen und in einer weiteren Kassette abgelegt.

Die genannten Wafer (Siliciumscheiben) sind sehr dünn (meist unter 1,0 mm, häufig unter 0,2 mm Dicke) und in der Regel als Kreisscheiben konfektioniert.

Der gesamte Bearbeitungsprozeß, wie er vorstehend dargestellt wurde, erfolgt unter Reinstraumbedingungen, da bereits kleinste Verunreinigungen den Wafer ansonsten unbrauchbar machen würden.

Neben diesem Erfordernis muß auch sichergestellt werden, daß der Wafer während der Handhabung (während des Transportes) und während der Bearbeitung nicht mechanisch verletzt oder verbogen wird.

In diesem Zusammenhang schlägt die AT 000 640 U1 einen Greifer für Halbleiterwafer und andere scheibenförmige Gegenstände vor, der relativ zu einem Grundkörper radial nach innen und nach außen verschiebbar geführte Greifarme aufweist. Die Siliciumscheiben werden dabei randseitig abschnittweise von den Greifarmen untergriffen, das heißt, die Scheiben liegen zumindest abschnittweise beim Transport auf den Greifarmen auf. Hierbei kann es, insbesondere bei sehr dünnen Scheiben, zu Verletzungen der Oberfläche oder Verwerfungen (einer Faltenbildung) der Scheiben kommen.

Gemäß der US 4,118,058 A wird ein Werkzeug zum kontaktfreien Transport von Scheiben vorgeschlagen, wobei ein entsprechender Träger randseitig Führungsflächen für die aufzulegende Scheibe aufweist. Nachteilig ist, daß bereits geringe Maßtoleranzen der zu transportierenden Scheibe entweder zu einer unkontrollierten seitlichen Bewegung der Scheibe führen oder die Scheibe gar nicht mehr aufgenommen werden kann. Aus der US 4 969 676 sind außerdem auswechselbare Führungsarme für Bernoulli-Heber bekannt.

Der Erfindung liegt insoweit die Aufgabe zugrunde, eine Vorrichtung anzubieten, mit der dünne, scheibenförmige Gegenstände ohne Beeinträchtigung ihrer Qualität und Form so schonend wie möglich transportiert werden können.

Dabei soll die Vorrichtung insbesondere zum Transport der genannten Wafer geeignet sein; insoweit unterliegt die Erfindung jedoch keinen Anwendungsbeschränkungen.

Grundgedanke der Erfindung ist es, die scheibenförmigen Gegenstände weitestgehend kontaktlos (ohne mechanische Kontaktstellen) zu transportieren. Dabei macht sich die Erfindung das sogenannte Bernoulli-Prinzip zunutze. Dabei wird zwischen einem Träger und dem zu behandelnden Gegenstand ein Gaspolster ausgebildet, wobei die Gasströmung derart erfolgt, daß zumindest abschnittweise zwischen dem Träger und dem Gegenstand ein Unterdruck ausgebildet wird, der dafür sorgt, daß der Gegenstand unter Aufrechterhaltung eines konstanten Abstands zur Oberfläche des Trägers gegen die Oberfläche des Trägers gesaugt wird.

Es wird also einerseits Gas unter Druck in einen Raum zwischen Träger und Gegenstand gebracht und andererseits ein Unterdruck aufgebaut, so daß ein kontaktloser Transport des Gegenstandes ermöglicht wird.

Um eine möglichst exakte Positionierung des Gegenstandes relativ zum Träger sicherzustellen, sind zusätzlich Führungsarme vorgesehen, die über die Oberfläche des Trägers vorstehen, eine exakte Zentrierung des Wafers ermöglichen und so eine seitliche (radiale) Verschiebung des Gegenstandes relativ zur Trägeroberfläche verhindern.

Diese Führungsarme haben also nicht die Aufgabe, den dünnen, scheibenförmigen Gegenstand zu greifen (wie die Greifarme gemäß der AT 000 640 U1). Sie bilden einstellbare umfangsseitige Justierflächen, Justierlinien oder bevorzugt Justierpunkte für die zu transportierenden Gegenstände.

In ihrer allgemeinsten Ausführungsform betrifft die Erfindung danach eine Vorrichtung zum Transport dünner, scheibenförmiger Gegenstände (nachstehend, jedoch nicht beschränkend, Wafer genannt) mit folgenden Merkmalen:
- einem Träger mit einer ebenen Fläche,
- im Träger sind eine oder mehrere Gaskanäle ausgebildet, die in Richtung auf die ebene Fläche nach außen geneigt verlaufend mit ihrem einen Ende in der ebenen Fläche mit (einer) Gasaustrittsöffnung(en) auslaufen und mit ihrem anderen Ende an eine Gaszuführleitung anschließbar sind,
- der/den Gasaustrittsöffnungen außenseitig benachbart sind mindestens drei Führungsarme angeordnet, die über die ebene Fläche des Träger vorstehen und radial zur ebenen Fläche des Trägers verstellbar sind, wobei die Führungsarme die gegenstande Zentrieren ohne bei zu greifen.

Der oder die Gaskanäle dienen dazu, ein Behandlungsgas, beispielsweise Stickstoff, in den Bereich der Trägeroberfläche (ebenen Fläche) zu transportieren. Sie sind nach außen geneigt, um den genannten Bernoulli-Effekt auszubilden. Der Gegenstand, der transportiert werden soll, überdeckt dabei die Gasaustrittsöffnungen des Gaskanals beziehungsweise der Gaskanäle, wobei entsprechend zwischen dem äußeren Randbereich des Wafers und der ebenen Fläche des Trägers ein Gaspolster ausgebildet wird, während zwischen dem mittleren Abschnitt des Wafers und dem korrespondierenden Abschnitt der ebenen Fläche ein Unterdruck ausgebildet wird, der den Wafer beabstandet zur Oberfläche des Trägers festhält, solange die genannten Druckverhältnisse zwischen Wafer und Trägeroberfläche aufrecht sind.

Nach einer Ausführungsform ist der Träger zweiteilig gestaltet. Zwischen den beiden Teilen des Trägers ist dann ein Gaskanal ausgebildet, der entsprechend der obengenannten geometrischen Vorgabe konisch (zur ebenen Fläche hin sich erweiternd) gestaltet ist.

Es ist selbstverständlich, daß in diesem Fall zwischen den Trägerteilen eine mechanische Verbindung bestehen muß. Diese Verbindung kann beispielsweise durch einen Bolzen ausgebildet werden, der die beiden Teile unter Ausbildung des Ringspalts (Gaskanals) in gewünschtem Abstand zueinander hält. Dabei kann dieser Bolzen gleichzeitig
als Gaszuführrohr dienen, das seitliche Öffnungen aufweist, über die das Gas vorzugsweise rotationssymmetrisch in den Gaskanal strömt.

Eine alternative Ausführungsform sieht eine Vorrichtung mit einem einteiligen Träger vor. In diesem Fall sind eine Vielzahl von Gaskanälen im Träger angeordnet, die beabstandet zueinander im wesentlichen rotationssymmetrisch zur Mittenlängsachse des Trägers angeordnet sind. Die Gaskanäle verlaufen dabei sternförmig und vorzugsweise mit sehr geringem Abstand zueinander, so daß auch auf diese Weise ein quasi kontinuierlicher Gasschleier ausgebildet werden kann.

Insbesondere wenn - wie üblich - rotationssymmetrische, vor allem runde Wafer transportiert werden sollen, sind auch die Führungsarme rotationssymmetrisch zur Mittenlängsachse des Trägers angeordnet.

Bezüglich der Ausbildung und Anordnung der Führungsarme bietet die Erfindung verschiedene Lösungsvorschläge an.

Nach einer Ausführungsform sind die Führungsarme am Träger angelenkt und bestehen jeweils aus einem ersten, vom Träger aus im wesentlichen senkrecht zur Mittenlängsachse des Trägers verlaufenden inneren Abschnitt und einem an das freie Ende des inneren Abschnitts anschließenden äußeren Abschnitt, der über die ebene Fläche des Trägers vorsteht.

In diesem Fall sind die Führungsarme nach Art der Beine einer Spinne gestaltet.

Die äußeren Abschnitte der Führungsarme können dabei im wesentlichen parallel zur Mittenlängsachse des Trägers verlaufen.

Um den Kontaktbereich zwischen der Außenfläche des Wafers und den Führungsarmen so gering wie möglich zu halten, sieht eine Weiterbildung vor, die äußeren Abschnitte der Führungsarme als Zylinder auszubilden. Verlaufen die Zylinder exakt parallel zur Mittenlängsachse des Trägers (und damit senkrecht zur ebenen Fläche des Trägers beziehungsweise senkrecht zum Wafer), kann es zwischen dem Randbereich des Wafers und den Zylindern maximal zu einer linienförmigen Kontaktierung kommen, wenn die Außenfläche des Wafers senkrecht zur Grundfläche verläuft oder nur zu einer punktförmigen Kontaktierung , wenn die Außenfläche (Umfangsfläche) des Wafers abgeschrägt gestaltet ist.

Sind die äußeren Abschnitte der Führungsarme mit einer gekrümmten Oberfläche, insbesondere nach Art einer Kugel, gestaltet, und wird der Wafer exakt in Höhe des Mittelpunktes der Kugel positioniert, ergeben sich in jedem Fall nur punktförmige Kontaktstellen zwischen dem Wafer und den Führungsarmen.

Dabei genügt es, insbesondere bei Ringscheiben, drei Führungsarme anzuordnen, die beispielsweise im Winkel von 120° zueinander versetzt angeordnet sind. Es ist aber ohne weiteres möglich, auch mehrere Führungsarme, beispielsweise sechs Führungsarme, dann im Winkel von 60° zueinander, anzuordnen.

Eine andere konstruktive Gestaltung sieht vor, die Führungsarme im Randbereich der ebenen Fläche, und zwar außerhalb des Gaskanals (der Gaskanäle) anzuordnen.

Dabei können diese Führungsarme analog den äußeren Abschnitten der vorgenannten Führungsarme gestaltet sein, also beispielsweise stiftförmig, zylinderförmig oder kugelförmig.

Dabei sollen die Führungsarme verstellbar sein, und zwar so, daß sie in einer Ebene parallel zur Trägeroberfläche einstellbar sind. Hierdurch wird eine Adaptierung der Position der Führungsarme an jegliche Geometrie oder Maßtoleranzen des Wafers ermöglicht. Die Führungsarme sind entsprechend senkrecht zur Mittenlängsachse des Trägers oder radial zur Trägeroberfläche bewegbar.

Bei einer Ausführungsform, bei der die Führungsarme beziehungsweise deren auf den Wafer wirkenden Abschnitte stiftartig gestaltet sind, kann dies zum Beispiel durch eine Exzenterverschiebung (Verschwenkung) erfolgen. Auch können die Führungsarme nach innen (in Richtung auf den Randbereich des Wafers) zugbelastet angeordnet werden, und zwar mit sehr geringer Zugkraft.

Der oben skizzierte Bernoulli-Effekt wird dann optimiert, wenn der oder die Gaskanäle zum gasaustrittsseitigen Ende hin verjüngend ausgebildet sind. Im Fall der beschriebenen ringförmigen Düse ist diese dann nach Art einer Schlitzdüse ausgebildet. Im Fall einzelner Gaskanäle weisen diese dann an ihrem gasaustrittsseitigen Ende beispielsweise eine Kegelstumpfform auf oder sind ebenfalls schlitzartig gestaltet.

Ein wesentlicher Vorteil der Vorrichtung besteht darin, daß die Wafer nicht mehr festgeklemmt werden. Die Wafer können sich entsprechend auch nicht mehr verbiegen oder falten. Es wurde sogar festgestellt, daß leicht verworfene Wafer sich in der Vorrichtung wieder glätten. Ein weiterer Vorteil besteht darin, daß die Wafer in einem definierten Abstand zur Trägeroberfläche unter Zwischenschaltung eines Gaspolsters kontaktlos gehalten werden. Dabei ist wesentlich, daß zwischen Wafer und Trägeroberfläche ein konstanter und gleichzeitig geringer Abstand ausgebildet wird.

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher beschrieben.

Dabei zeigen - jeweils in schematisierter Darstellung -
- Figur 1:: einen Längsschnitt durch eine erfindungsgemäße Transportvorrichtung,
- Figur 2:: eine Aufsicht (von oben) auf die Führungsarme der Vorrichtung.

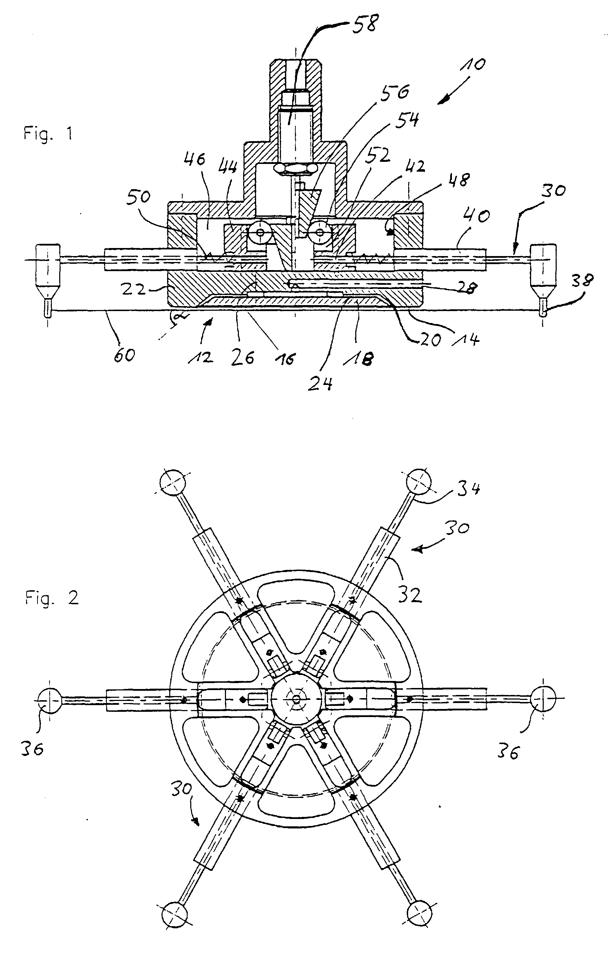

In Figur 1 beschreibt das Bezugszeichen 10 einen Träger der Vorrichtung. Der Träger weist eine ebene Oberfläche 12 auf. Die Oberfläche 12 besteht aus zwei Abschnitten, einem äußeren Ringbereich 14 und einem inneren Kreisbereich 16. Der Kreisbereich 16 stellt die Oberfläche eines Einsatzes 18 dar, der unter Ausbildung eines Ringspaltes 20 in einer korrespondierenden Vertiefung 24 eines Grundkörpers 22 des Trägers 10 angeordnet ist.

Der Einsatz 18 ist dabei über drei Schrauben 26 mit dem Grundkörper 22 verbunden.

Der Ringspalt 20 bildet einen Gaskanal, dessen in der Oberfläche 12 auslaufendes Ende schlitzartig verjüngend ausgebildet ist und dessen anderes Ende in strömungstechnischer Verbindung zu einer im Gehäusekörper 22 ausgebildeten Gaszuführleitung 28 steht, welche an eine Druckgasquelle (nicht dargestellt) anschließbar ist.

Die Oberflächen des Einsatzes 18 beziehungsweise des Grundkörpers 22, also der Kreisbereich 16 und der Ringbereich 14 sind exakt fluchtend zueinander ausgerichtet und beschreiben gemeinsam die ebene Oberfläche 12 des Trägers 10.

Durch den Grundkörper 22 erstrecken sich, wie sich aus einer Zusammenschau der Figuren 1 und 2 ergibt, sechs Führungsarme 30, die jeweils einen Winkel von 60° zueinander aufweisen. Jeder Führungsarm 30 besteht aus einem ersten, vom Träger 10 aus im wesentlichen senkrecht zur Mittenlängsachse M des Trägers verlaufenden inneren Abschnitt 32 und einem, an das freie Ende 34 des inneren Abschnitts 32 anschließenden äußeren Abschnitt 36. Die äußeren Abschnitte 36 verlaufen senkrecht zu den inneren Abschnitten 30 und damit senkrecht zur Oberfläche 12 beziehungsweise parallel zur Mittenlängsachse M des Trägers 10.

Sie sind so angeordnet, daß ihre freien, zylinderförmigen Enden 38 über die Oberfläche 12 vorstehen.

Die inneren Abschnitte 32 der Führungsarme 30 sind durch Hülsen 40 geführt, die im Gehäusekörper 22 festgelegt sind. Mit ihrem inneren Ende 42 sind die Abschnitte 32 an korrespondierenden Gleitkörpern 44 fixiert. Zwischen den Gleitkörpern 44, die in einer Ausnehmung 46 des Grundkörpers 22 liegen und der gegenüberliegenden Innenwand 48 des Grundkörpers 22 sind Druckfedern 50 auf den Abschnitten 32 angeordnet. Innenseitig weisen die Gleitkörper 44 Ausnehmungen 52 auf, in denen Rollen 54 angeordnet sind, die mit keilförmigen Justierkörpern 56 zusammenwirken, die von einem Stößel 58 im oberen Abschnitt des Grundkörpers 22 beaufschlagbar sind.

Durch eine Axialverstellung des Stößels 58 werden die Justierkörper 56 in Richtung der Mittenlängsachse M des Trägers 10 geführt und bei einer Bewegung in Richtung auf die Oberfläche 12 werden entsprechend die Führungsarme 30 radial nach außen bewegt. Wird der Stößel 58 zurückgeführt, sorgen die Druckfedern 50 dafür, daß die Führungsarme 30 wieder nach innen zurückbewegt werden.

Der Träger 10 ist an einem (nicht dargestellten) Manipulator befestigt, der den Träger 10 an eine gewünschte Position bringt, an der ein Wafer aufgenommen wird und an eine andere Stelle führt, an der der Wafer wieder abgelegt wird.

Dabei ist die Funktion der Vorrichtung wie folgt:

Der zum Beispiel auf einem Chuck liegende Wafer 60 wird von der Vorrichtung übergriffen (wie in Figur 1 dargestellt). Die Gaszufuhr wird angeschaltet und Gas strömt durch die Gaszuführleitung 28 und den Gaskanal (Ringspalt 20) aus. Entsprechend der schräg nach außen geneigten Form des Ringspaltes 20 strömt auch das Gas unter einem spitzen Winkel Alpha zur Oberfläche 12 in Richtung auf den Wafer 60. Auf diese Weise wird der Wafer 60 zunächst im Abstand zur Oberfläche 12 gehalten. Gleichzeitig bildet sich innerhalb des ringförmigen Gasschleiers, also insbesondere zwischen dem Kreisbereich 16 und dem korrespondierenden Abschnitt des Wafers 60 ein Unterdruck aus (sogenannter Bernoulli-Effekt), der den Wafer 60 in definiertem Abstand zur Oberfläche 12 hält beziehungsweise an diese zieht.

Der Träger kann nun über den Manipulator angehoben werden, wobei er kontaktlos den Wafer mitnimmt. Der Manipulator kann jede beliebige, vorzugsweise elektronisch gesteuerte Einrichtung sein, zum Beispiel ein sogenannter Handhabungs-Roboter.

Zur Sicherheit dienen die Führungsarme 30 beziehungsweise ihre zylinderförmigen Enden 38, die (gegebenenfalls nach entsprechender Einstellung) den Wafer 60 randseitig begrenzen und so ein seitliches Auswandern des Wafers 60 verhindern. Im Normalfall wird es dabei zu keinem kraftübertragenden Kontakt zwischen dem Randbereich des Wafers 60 und den zylinderförmigen Enden 38 kommen. Sofern der Wafer 60 sich jedoch radial wegbewegen sollte (während des Greifvorgangs oder des Transportes), kann der Wafer maximal punktuell an den zylinderförmigen Enden 38 sanft anliegen.

Der Wafer wird anschließend beispielsweise in einer Kassette abgelegt.

## Patentansprüche

1. Vorrichtung zum Transport dünner, scheibenförmiger Gegenstände (60), gekennzeichnet durch folgende Merkmale:
1.1 einen Träger (10) mit einer ebenen Fläche (12),
1.2 im Träger (10) sind ein oder mehrere Gaskanäle (20) ausgebildet, die in Richtung auf die ebene Fläche (12) nach außen geneigt verlaufend mit ihrem einen Ende in der ebenen Fläche (12) mit einer oder mehreren Gasaustrittsöffnungen auslaufen und an ihrem anderen Ende an eine Gaszuführleitung (28) anschließbar sind,
1.3 der oder den Gasaustrittsöffnungen außenseitig benachbart sind mindestens drei Führungsarme (30) angeordnet, die über die ebene Fläche (12) des Trägers (10) vorstehen und radial zur ebenen Fläche (12) verstellbar sind, wobei die Führungsarme (30) die gegenstande (60) zentrieren ohne bei zu greifen.

2. Vorrichtung nach Anspruch 1, gekennzeichnet durch einen zweiteiligen Träger (18, 22) und einen zwischen den Trägerteilen (18, 22) ausgebildeten, im wesentlichen konisch gestalteten Ringkanal (20).

3. Vorrichtung nach Anspruch 1, gekennzeichnet durch einen einteiligen Träger mit einer Vielzahl von Gaskanälen, die beabstandet zueinander und im wesentlichen rotationssymmetrisch zur Mittenlängsachse (M) des Trägers (10) angeordnet sind.

4. Vorrichtung nach Anspruch 1, dadurch gekennzeichnet, daß die Führungsarme (30) rotationssymmetrisch zur Mittenlängsachse (M) des Trägers (10) angeordnet sind.

5. Vorrichtung nach Anspruch 1, dadurch gekennzeichnet, daß die Führungsarme (30) am Träger (10) angelenkt sind und jeweils aus einem ersten, vom Träger (10) aus im wesentlichen senkrecht zur Mittenlängsachse (M) des Trägers (10) verlaufenden inneren Abschnitt (32) und einem an das freie Ende (34) des inneren Abschnitts (32) anschließenden äußeren Abschnitt (36) bestehen, der über die ebene Fläche (12) des Trägers (10) vorsteht.

6. Vorrichtung nach Anspruch 5, dadurch gekennzeichnet, daß die äußeren Abschnitte (36) der Führungsarme (30) im wesentlichen parallel zur Mittenlängsachse (M) des Trägers (10) verlaufen.

7. Vorrichtung nach Anspruch 5, dadurch gekennzeichnet, daß die äußeren Abschnitte (36) eine Zylinderform aufweisen.

8. Vorrichtung nach Anspruch 5, dadurch gekennzeichnet, daß die äußeren Abschnitte eine Kugelform aufweisen.

9. Vorrichtung nach Anspruch 1, dadurch gekennzeichnet, daß die Führungsarme vom Randbereich der ebenen Fläche außerhalb des (der) Gaskanäle abstehen.

10. Vorrichtung nach Anspruch 9, dadurch gekennzeichnet, daß die Führungsarme eine Zylinder- oder Kugelform, zumindest an ihrem freien Ende aufweisen.

11. Vorrichtung nach Anspruch 1, dadurch gekennzeichnet, daß die Führungsarme (30) in Richtung auf die Mittenlängsachse (M) des Trägers (10) bewegbar angeordnet sind.

12. Vorrichtung nach Anspruch 11, dadurch gekennzeichnet, daß die Führungsarme (30) in Richtung auf die Mittenlängsachse (M) des Trägers (10) verschwenkbar angeordnet sind.

13. Vorrichtung nach Anspruch 11, dadurch gekennzeichnet, daß die Führungsarme (30) zugbelastet angeordnet sind.

14. Vorrichtung nach Anspruch 1, dadurch gekennzeichnet, daß der Träger (10) eine kreisförmige ebene Fläche (14, 16) aufweist.

15. Vorrichtung nach Anspruch 1, dadurch gekennzeichnet, daß der (die) Gaskanal (Gaskanäle) im Bereich der Gasaustrittsöffnung schlitzförmig ausgebildet ist (sind).

## Claims

1. Device for transporting thin, disc-shaped objects (60) characterised by the following features:
1.1 a carrier (10) with a flat face (12),
1.2 one or more gas channels (20) are configured in the carrier (10), which channels (20) extend outwardly at an inclination and discharge in the direction of the flat face (12) with its/their one end in the flat face (12) by means of one or more gas outlet openings, and which channels (20) are connectable to a gas supply pipe (28) by means of the other end of said channel(s),
1.3 at least three guiding arms (30) are disposed externally adjacent to the gas outlet opening/openings, which guiding arms protrude beyond the flat face (12) of the carrier (10) and are displaceable radially relative to the flat face (12), the guiding arms (30) centring the objects (60) without gripping them.

2. Device according to claim 1, characterised by a two-part carrier (18, 22) and an annular channel (20) which is configured between the parts of the carrier (18, 22) and has a substantially conical configuration.

3. Device according to claim 1, characterised by a one-part carrier with a multiplicity of gas channels which are disposed at a spacing from each other and in a substantially rotationally symmetrical manner relative to the central longitudinal axis (M) of the carrier (10).

4. Device according to claim 1, characterised in that the guiding arms (30) are disposed in a rotationally symmetrical manner relative to the central longitudinal axis (M) of the carrier (10).

5. Device according to claim 1, characterised in that the guiding arms (30) are linked to the carrier (10) and comprise respectively a first internal portion (32) which extends from the carrier (10) substantially perpendicularly relative to the central longitudinal axis (M) of the carrier (10), and an external portion (36) which abuts against the free end (34) of the internal portion (32) and protrudes beyond the flat face (12) of the carrier (10).

6. Device according to claim 5, characterised in that the external portions (36) of the guiding arms (30) extend substantially parallel to the central longitudinal axis (M) of the carrier (10).

7. Device according to claim 5, characterised in that the external portions (36) have a cylindrical configuration.

8. Device according to claim 5, characterised in that the external portions have a spherical configuration.

9. Device according to claim 1, characterised in that the guiding arms are at a spacing from the edge region of the flat face externally of the gas channel (channels).

10. Device according to claim 9, characterised in that the guiding arms have a cylindrical or spherical configuration, at least at their free end.

11. Device according to claim 1, characterised in that the guiding arms (30) are disposed so as to be movable in the direction of the central longitudinal axis (M) of the carrier (10).

12. Device according to claim 11, characterised in that the guiding arms (30) are disposed so as to be able to sweep horizontally in the direction of the central longitudinal axis (M) of the carrier (10).

13. Device according to claim 11, characterised in that the guiding arms (30) are disposed with a tensile load.

14. Device according to claim 1, characterised in that the carrier (10) has a circular, flat face (14, 16).

15. Device according to claim 1, characterised in that the gas channel (channels) has (have) a slot-shaped configuration in the region of the gas outlet opening.

## Revendications

1. Dispositif pour le transport d'articles (60) fins, circulaires, caractérisé par les caractéristiques suivantes:
1.1 un support (10) avec une surface (12) plane,
1.2 dans le support (10) est (sont) aménagé(s) un ou plusieurs canal (canaux) (20) de passage de gaz, qui s'étend(ent) en direction de la surface (12) plane, en étant incliné(s), à une extrémité débouche(nt) dans la surface (12) plane par un(des) orifice(s) de sortie de gaz et à l'autre extrémité peut (peuvent) être connecté(s) à une conduite d'arrivée de gaz (28),
1.3 dans le voisinage de l'orifice (des orifices) de sortie de gaz, côté extérieur, sont disposés au moins trois bras de guidage (30) qui s'étendent au-dessus de la surface plane (12) du support (10) et peuvent être réglés radialement par rapport à la surface (12) plane.

2. Dispositif selon la revendication 1, caractérisé par un support (18, 22) en deux parties et un canal annulaire (20) essentiellement conique aménagé entre les parties de support (18, 22).

3. Dispositif selon la revendication 1, caractérisé par un support (18, 22) en une seule partie avec plusieurs canaux de passage de gaz qui sont disposés à distance les uns des autres et essentiellement avec symétrie de révolution par rapport à l'axe médian longitudinal (M) du support (10).

4. Dispositif selon la revendication 1, caractérisé en ce que les bras de guidage (30) sont disposés de manière symétrique de révolution par rapport à l'axe médian longitudinal (M) du support (10).

5. Dispositif selon la revendication 1, caractérisé en ce que les bras de guidage (30) sont articulés sur le support (10) et sont formés chacun d'un premier tronçon (32) intérieur essentiellement perpendiculaire à l'axe médian longitudinal (M) du support (10) et d'un tronçon extérieur (36) qui se raccorde à l'extrémité libre (34) du tronçon intérieur (32) et s'étend au-dessus la surface (12) plane du support (10).

6. Dispositif selon la revendication 5, caractérisé en ce que les tronçons extérieurs (36) des bras de guidage (30) sont essentiellement parallèles à l'axe médian longitudinal (M) du support (10).

7. Dispositif selon la revendication 5, caractérisé en ce que les tronçons extérieurs (36) ont une forme cylindrique.

8. Dispositif selon la revendication 5, caractérisé en ce que les tronçons extérieurs (36) ont une forme sphérique.

9. Dispositif selon la revendication 1, caractérisé en ce que les bras de guidage sont écartés de la zone de bord de la surface plane à l'extérieur du (des) canal (canaux) de passage de gaz.

10. Dispositif selon la revendication 9, caractérisé en ce que les bras de guidage, au moins à leur extrémité libre, ont une forme cylindrique ou sphérique.

11. Dispositif selon la revendication 1, caractérisé en ce que les bras de guidage (30) sont montés mobiles dans la direction de l'axe médian longitudinal (M) du support (10).

12. Dispositif selon la revendication 11, caractérisé en ce que les bras de guidage sont montés pivotants dans la direction de l'axe médian longitudinal (M) du support (10).

13. Dispositif selon la revendication 11, caractérisé en ce que les bras de guidage (30) sont sollicités en traction.

14. Dispositif selon la revendication 1, caractérisé en ce que le support (10) comporte une surface (14, 15) circulaire.

15. Dispositif selon la revendication 1, caractérisé en ce que le (les) canal (canaux) de passage de gaz, dans la région de l'orifice de sortie, est (sont) conformé(s) en fentes.
